## Europäisches Patentamt
## European Patent Office
## Office européen des brevets

(11) Veröffentlichungsnummer : **0 029 887**
**B1**

(12) **EUROPÄISCHE PATENTSCHRIFT**

(45) Veröffentlichungstag der Patentschrift :
13.07.83

(21) Anmeldenummer : 80105789.4

(22) Anmeldetag : 25.09.80

(51) Int. Cl.³ : **H 01 L 21/225**, H 01 L 21/31,
H 01 L 29/08

(54) Verfahren zum Herstellen eines vertikalen PNP-Transistors und so hergestellter Transistor.

(30) Priorität : 03.12.79 US 99695

(43) Veröffentlichungstag der Anmeldung :
10.06.81 Patentblatt 81/23

(45) Bekanntmachung des Hinweises auf die Patenterteilung : 13.07.83 Patentblatt 83/28

(84) Benannte Vertragsstaaten :
DE FR GB

(56) Entgegenhaltungen :
DE A 2 640 465
FR A 2 288 391
FR A 2 371 779
FR A 2 389 236
FR A 2 433 833
GB A 2 014 785
NL A 7 604 445

APPLIED PHYSICS LETTERS, Band 32, 1. Februar 1978, New York, US, R. T. YOUNG et al. : « Laser annealing of boron-implanted silicon », Seiten 139-141

IBM TECHNICAL DISCLOSURE BULLETIN, Band 21, Dezember 1978, New York, US, N. G. ANANTHA et al. : « Method for making lateral PNP devices using polycrystalline silicon », Seiten 2753-2754

(73) Patentinhaber : International Business Machines Corporation
Old Orchard Road
Armonk, N.Y. 10504 (US)

(72) Erfinder : Magdo, Ingrid Emese
Frances Drive
Hopewell Junction, N.Y. 12533 (US)

(74) Vertreter : Gaugel, Heinz, Dipl.-Ing.
Schönaicher Strasse 220
D-7030 Böblingen (DE)

## Verfahren zum Herstellen eines vertikalen PNP-Transistors und so hergestellter Transistor

Die Erfindung betrifft ein Verfahren zum Herstellen eines vertikalen PNP-Transistors mit flacher, einen steilen Störstellengradienten bei hoher Störstellenkonzentration aufweisender und fehlstellenfreier P-dotierter Emitterzone in einer in ein P-dotiertes Halbleitersubstrat eingebrachten N-dotierten Basiszone gemäß dem ersten Teil des Anspruchs 1.

Es wird seit langem versucht, PNP-Transistoren herzustellen, deren elektrische Eigenschaften denen der NPN-Transistoren vergleichbar sind, um damit komplementäre Halbleiterstrukturen herstellen zu können, die gleichwertige PNP- und NPN-Transistoren aufweisen. Es ist jedoch bekannt, daß die Verstärkungs- und Frequenzeigenschaften von PNP-Transistoren weniger gut sind, als die von NPN-Transistoren. Man war sich klar darüber, daß man in ihren Eigenschaften verbesserte PNP-Transistoren dadurch erzielen kann, daß man flache, P-dotierte Emitterzonen mit kontrollierter Störstellenkonzentration und mit einer fehlstellenfreien Kristallstruktur verwirklicht. Unter einer flachen Emitterzone versteht man dabei Emitterzonen, deren von der Halbleiteroberfläche ausgehende Tiefe geringer als 300 nm ist. Bei der Verwirklichung solch flacher P-dotierter Emitterzonen sind zahlreiche Probleme aufgetaucht.

Beispielsweise bildet sich bei der Implantation von Bor in hohen Dosen in monokristallinem Silicium eine sehr hohe Dichte von Versetzungsschleifen, die sich ausgehend von der Oberfläche bis zu einer Tiefe von etwa 50 nm erstrecken. Mit zunehmender Tiefe laufen diese Versetzungsschleifen in sehr dichte, verwickelte Versetzungszustände zusammen, die sich dann bis zu einer Tiefe von etwa 200 nm erstrecken. Versuche, durch Erwärmungsprozesse diese Versetzungen auszuheilen, blieben wirkungslos. Nach Durchführung des Erwärmungsprozesses fand man in einer Tiefe von etwa 200-500 nm eine weitere Schicht von Stapelfehlern. Diese Stapelfehler liegen in einem Gebiet des monokristallinen Siliziums, in dem eine Implantation nicht mehr stattgefunden hat. Diese Stapelfehler werden durch Diffusion von Bor während des Erwärmungsprozesses mit erzeugt.

Versuche, P-dotierte Emitterzonen durch Implantation von Bor bei niedrigeren Konzentrationen zu erhalten, blieben ebenfalls wirkungslos. Die geringere Dosis führt zu Störstellenkonzentrationen, die das Erreichen der angestrebten elektrischen Eigenschaften nicht gewährleisten. Erhöht man die Dosis, gelangt man wiederum schnell in den Bereich, in dem die beschriebenen Versetzungen entstehen, die nicht ausheilbar sind.

Ein weiteres Problem erwächst daraus, daß die Diffusionsgeschwindigkeit von Bor in Silicium sehr hoch ist. Das bedeutet, daß bei dem Versuch, durch einen Erwärmungsprozeß die infolge der hohen Konzentration entstandenen Versetzungen auszuheilen, das Bor unzulässig weit ausdiffundiert.

Aus den genannten Gründen hat man bisher bei der Herstellung von PNP-Transistoren eine Implantation der Emitterzone nicht in betracht gezogen.

Vergleichbare Probleme sind bei der Herstellung von NPN-Transistoren nicht festzustellen. Die durch die Implantation von Ionen des N-Typs entstehenden Kristallschäden, lassen sich leicht durch eine Erwärmung ausheilen. Obwohl an der Oberfläche des Siliziums einige Fehlstellen oder Versetzungsfehler auch nach dem Ausheilen im Anschluß an eine Implantation von Ionen des N-Typs erhalten bleiben, sind die entsprechenderweise hergestellten Transistoren im Hinblick auf die sich ergebende Tiefe der Emitterzone und die Anzahl und Ausbreitung der Fehlstellen als gut zu bezeichnen. Trotzdem hat man Methoden entwickelt, um Transistoren mit implantierten, N-dotierten Emitterzonen weiter zu verbessern.

Beispielsweise ist in der amerikanischen Patentschrift Nr. 3 460 007 ein Verfahren zur Herstellung eines PN-Überganges beschrieben, bei dem auf die Oberfläche des monokristallinen Halbleitersubstrates eine N-dotierte polykristalline Siliziumschicht aufgebracht wird. Diese Struktur wird anschließend erwärmt, um das N-Störstellenmaterial in das Halbleitersubstrat einzutreiben und dort die Emitterzone zu bilden. Für N-dotierte Emitterzonen ergeben sich bei diesem Verfahren bestimmte Vorteile. Ein Verfahren zur Herstellung der N-dotierten Emitterzone eines NPN-Transistors wird auch in « IEEE Journal of Solid State Circuits, Vol. SC-11, No. 4, August 1976, Seiten 91-493, sowie in der FR-A-2 288 391 beschrieben. Bei diesem Verfahren wird auf die Oberfläche eines monokristallinen Halbleitersubstrates eine undotierte polykristalline Schicht aufgebracht. Durch Implantation von beispielsweise Arsen wird die Schicht N-dotiert. In einem Erwärmungsprozess wird das Arsen aus der polykristallinen Schicht in das monokristalline Halbleitersubstrat eingetrieben und bildet dort die N-dotierte Emitterzone. Auf diese Weise erhält man eine N-dotierte Emitterzone eines NPN-transistors mit gutem Emitterwirkungsgrad und hoher zulässiger Strombelastung.

Auf grund der zwischen Störstellenmaterial des N-Leitungstyps und Störstellenmaterial des P-Leitungstyps bestehenden Unterschiede in den physikalischen Eigenschaften wurde stets angenommen, daß sich P-dotierte Emitterzonen nicht durch Diffusion aus einer entsprechend dotierten polykristallinen Schicht herstellen lassen. Beim Verfahren, bei dem auf das Halbleitersubstrat bereits eine dotierte polykristalline Siliziumschicht aufgebracht wird, ist es nicht möglich, eine genügend hohe P-Störstellenkonzentration zu erzeugen, wie sie für eine Emitterzone gefordert wird. Ein weiteres Problem erwächst aus

der Tatsache, daß stets angenommen wurde, daß die Eintreibeigenschaften von Ionen des P-Leitungstyps nicht geeignet sind, um flache Emitterzonen einzudiffundieren. Außerdem war man der Auffassung, daß eine Ionen-implantation von undotierten polykristallinen Siliziumschichten Versetzungen in der Siliziumoberfläche erzeugt, die während des Erwärmungsprozesses zum Eintreiben sich weiter ausdehnen.

Der vorstehend geschilderte technische Sachverhalt und die daraus gezogenen Schlüsse finden ihre Stütze in der Fachliteratur. Beispielsweise wird auf einen Artikel « Application of Diffusion from Implanted Polycrystalline Silicon to Bipolar Transistors » in Japanese Journal of Applied Physics, Vol. 15 (1976), Supplement 15-1, Seiten 49-54, sowie auf die GB-A-2 014 785 verwiesen. Dort wird zur Herstellung einer P-dotierten Basiszone in einem Siliziumsubstrat ein Verfahren angegeben, bei dem eine auf das Halbleitersubstrat aufgebrachte polykristalline Schicht als Diffusionsquelle dient. In die polykristalline Schicht wird Bor in niedriger, unterhalb der kritischen Dosis liegenden Konzentration implantiert, bei der noch keine Schäden entstehen, die Oberflächenfehlstellen an der Grenzfläche zwischen der polykristallinen Schicht und dem Halbleitersubstrat führen können. In einem anschließenden Erwärmungsprozess diffundieren die Boratome bis zu einer Tiefe von etwa 1 000 nm in das Halbleitersubstrat ein und bilden die P-dotierte Basiszone. Bisher sind keine Berichte bekannt oder Versuche unternommen worden, P-dotierte Emitterzonen für PNP-Transistoren durch Diffusion aus einer dotierten polykristallinen Siliziumschicht herzustellen und zwar weder aus bereits vorher dotierten als auch aus nach dem Aufbringen durch Ionenimplantation dotierten polykristallinen Schichten.

Die Erfindung, wie sie in den Ansprüchen gekennzeichnet ist, löst die Aufgabe, ein Verfahren zum Herstellen einer P-dotierten Emitterzone für einen vertikalen PNP-Transistor anzugeben, die flach ist, einen steilen Störstellengradienten hat und möglichst wenig herstellungsbedingte Fehlstellen aufweist.

Die durch die Erfindung erreichten Vorteile sind guten elektrischen Eigenschaften des PNP-Transistors, wie z. B. hoher Verstärkung und gutem Frequenzverhalten, zu finden.

Zusammengefaßt läßt sich das erfindungsgemäße Verfahren folgendermaßen darstellen :

Zunächst wirkt auf der Oberfläche eines Silizium-Halbleitersubstrates, in dem sich eine N-dotierte Basiszone befindet, ein die zu verwirklichende Emitterzone definierendes Maskenfenster gebildet. Im Bereich des Maskenfensters wird eine polykristalline Schicht aus Silizium auf die Oberfläche des Halbleitersubstrates aufgebracht. In die polykristalline Schicht werden unter den im kennzeichnenden Teil des Anspruchs 1 angegebenen Prozeßbedingungen P-Leitfähigkeit erzeugende Störstellen implantiert. Die Störstellen werden in einem anschließenden Erwärmungsprozeß unter den in den abhängigen Ansprüchen genannten Prozeßparametern in die Basiszone eindiffundiert und bilden dort die flache P-dotierte Emitterzone.

Im folgenden wird die Erfindung an hand von lediglich einen Ausführungsweg darstellenden Verfahrensschritten näher erläutert. Es zeigen

Figuren 1-4 Schnittansichten einer Transistorstruktur in aufeinanderfolgenden Prozeßschritten des erfindungsgemäßen Herstellungsverfahrens,

Figur 5 ein mögliches Dotierungsprofil des Transistors gemäß Fig. 4,

Figuren 6 bis 8 Schnittansichten eines weiteren Ausführungsbeispiels einer Transistorstruktur in aufeinanderfolgenden Prozeßschritten des erfindungsgemäßen Herstellungsverfahrens, bei dem eine doppelte polykristalline Siliziumschicht verwendet wird,

Figuren 9 bis 14 Darstellungen der Beziehungen verschiedener Betriebsgrößen in Verbindung mit dem erfindungsgemäßen Verfahren,

Figur 15 . einen Vergleich der Emitterstrukturen, hergestellt nach einem Verfahren gemäß der Erfindung und einem Verfahren gemäß dem Stand der Technik,

Figur 16 verschiedene Prozeßparameter des erfindungsgemäßen Verfahrens.

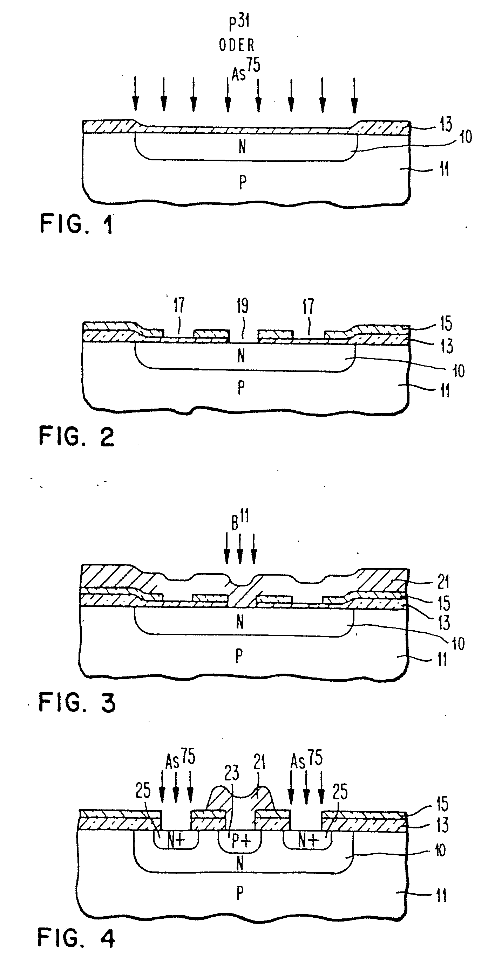

Zunächst sei das erste Ausführungsbeispiel anhand der Figuren 1-4 näher betrachtet. Eine Basiszone 10 und eine nicht dargestellte Subkollektor-Kontaktierungszone sind in bekannter Weise in ein monokristallines Halbleitersubstrat 11 aus Silizium eingebracht, wie es in Fig. 1 schematisch dargestellt ist. Die Basiszone 10 ist mit einer Siliziumdioxidschicht 13 abgedeckt, die während der Diffusion der Basiszone 10 entstanden ist. Auf die Siliziumdioxidschicht 13 wird wie in Fig. 2 gezeigt eine Siliziumnitridschicht 15 aufgebracht. In einem Photoätzprozeß werden in der Siliziumnitridschicht 15 in üblicher Weise das Basiskontaktfenster 17 und das Emitterfenster 19 geöffnet. Das Emitterfenster 19 wird anschließend auch in der Siliziumdioxidschicht 13 unter Verwendung eines geeigneten Ätzmittels oder durch reaktives Ionenätzen freigelegt. Anschließend wird auf die gesamte Oberfläche des Halbleitersubstrates eine polykristalline Siliziumschicht 21 (Fig. 3) aufgebracht. Die polykristalline Siliziumschicht 21 wird dann unter spezifischen Bedingungen, die noch im einzelnen angegeben werden, durch Ionenimplantation P-dotiert. Vorzugsweise erfolgt eine Implantation von Borionen. Die polykristalline Schicht 21 wird nunmehr soweit abgeätzt, daß nur noch ein Schichtbereich in und in der Umgebung des Emitterfensters erhalten bleibt. Im folgenden Prozeßschritt wird die Anordnung einem Erwärmungsprozeß ausgesetzt, was beispielsweise auch durch Laserbestrahlung erfolgen kann, wobei unter bestimmten Bedingungen das Bor aus der im Bereich des Emitterfensters 19 vorhandenen restlichen polykristallinen Schicht 21 in die Basiszone 10 eindiffundiert und dort eine $P^+$-Emitterzone 23 bildet (Fig. 4). Anschließend wird das Basiskontaktfenster 17 in der Siliziumdioxidschicht 13 bis auf die Oberfläche des Halbleiters 11 freigeätzt. Durch Ionenimplantation, beispielsweise von $As^{75}$ oder $P^{31}$ werden die N-dotierten Basiskontaktzonen 25 erzeugt. Schließlich wird die Anordnung in bekannter Weise metallisiert. Da die dotierte Polysiliziumschicht 21 im Bereich der Emitterzone 23 eine ausreichende Leitfähigkeit aufweist, um einen guten Ohm'schen Kontakt zur Emitterzone zu bilden, kann diese polykristalline Siliziumschicht als Emitterkontakt belassen und verwendet werden, falls nicht ein metallischer Emitterkontakt verwendet werden soll.

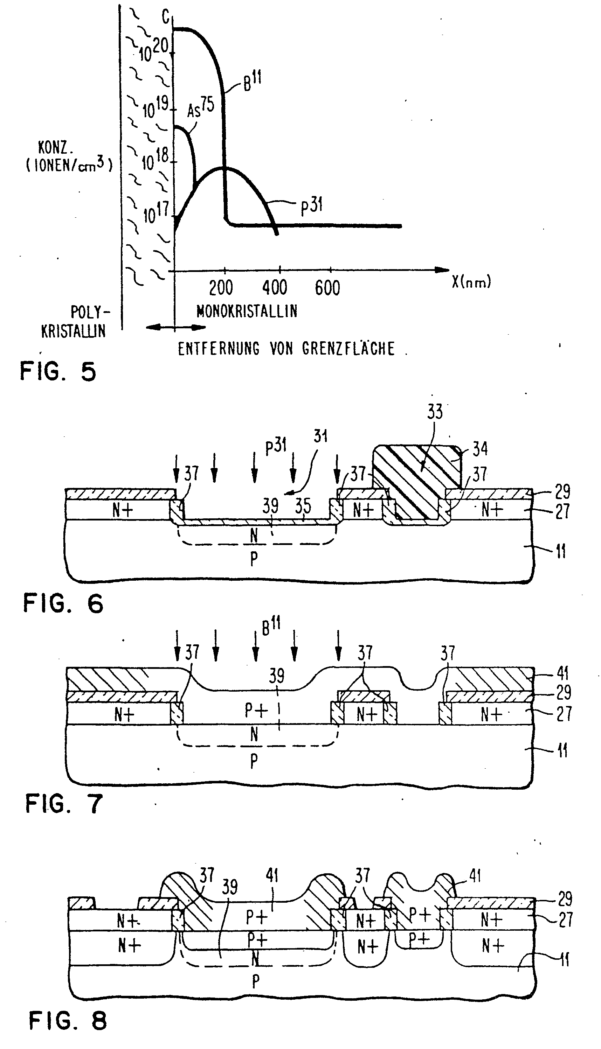

Das Dotierungsprofil des in der beschriebenen Weise hergestellten PNP-Transistors ist der Fig. 5 zu entnehmen. Es zeigt sich, daß die durch das Profil $P^{11}$ definierte Emitterzone sehr flach ist und sich ausgehend von der Grenzfläche zwischen der polykristallinen Siliziumschicht und dem monokristallinen Halbleitersubstrat nur bis zu einer Entfernung X von etwa 200 nm in das Halbleitersubstrat erstreckt. Der Störstellengradient der Emitterzone verläuft extrem steil, was zu einem optimalen Profil führt. Die Stromverstärkung des PNP-Transistors ist im Vergleich zu bekannten PNP-Transistoren sehr hoch. Man hat Stromverstärkungen größer 200 erreicht im Vergleich zu Stromverstärkungen konventioneller PNP-Transistoren von weniger als 10. Die Grenzfrequenz ist ebenfalls hoch, beispielsweise 3,6 GHz im Vergleich zu 500 MHz konventioneller PNP-Transistoren.

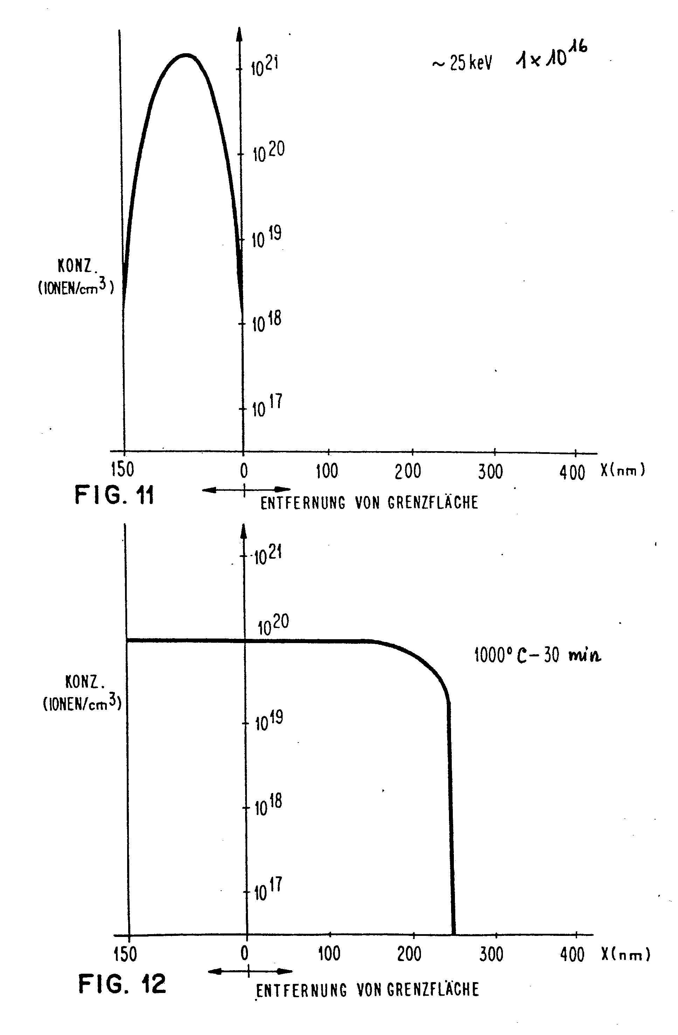

Der erfindungsgemäße vertikale, bipolare PNP-Transistor, gekennzeichnet durch eine Emitterzone mit einer Konzentration $(C_O)$ von P-dotierenden Ionen von mindestens $1 \times 10^{19}$ Ionen/$cm^3$, die sich bis zu mindestens 200 nm in das Halbleitersubstrat erstreckt und einer Konzentration $(C_O)$ von weniger als etwa $1 \times 10^{16}$ in einer Entfernung von 350 nm von der Oberfläche des Halbleitersubstrates nach dem Eintreiben. Vorzugsweise weist die Emitterzone eine Konzentration $(C_O)$ von mindestens $5 \times 10^{19}$ Ionen/$cm^3$ auf und erstreckt sich bis zu einer Tiefe von mindestens 150 nm und einer Konzentration von weniger als etwa $1 \times 10^{17}$ bei einer Tiefe von 300 nm. Man erhält einen Störstellengradienten (siehe Figuren 10, 12 und 14), der sich durch eine hohe, in der Nähe der Oberfläche des Halbleitersubstrats gleichbleibende und sich nur über eine geringe Entfernung in das Substrat erstreckende Konzentration auszeichnet und dann einem steilen Konzentrationsabfall aufzeigt. Diese Charakteristiken der Emitterzone sind ausschlaggebend für verbessertes Verstärkungs- und Frequenzverhalten des PNP-Transistors.

Das erfindungsgemäße Verfahren kann auch bei der Herstellung eines PNP-Transistors in der sog. Doppel-Polysilizium-Technik angewandt werden. Ein solches Verfahren ergibt sich aus den Figuren 6 bis 8. Auf ein monokristallines Halbleitersubstrat 11 aus Silizium ist eine polykristalline Siliziumschicht 27 aufgebracht. Die polykristalline Schicht 27 ist durch Ionenimplantation oder eine andere brauchbare Methode N-dotiert. Auf die polykristalline Schicht 27 wird eine pyrolythische Siliziumdioxidschicht 29 aufgebracht. Ein Fenster 31 für eine intrinsische Basiszone, das die gleiche Ausdehnung wie die zu bildende Emitterzone aufweist, wird in der Siliziumdioxidschicht 29 und in der polykristallinen Schicht 27 geöffnet. Ebenfalls geöffnet wird ein Kollektorkontaktfenster 33, das mit Photolack 34 bedeckt wird, wie es in Fig. 6 dargestellt wird.

Nach dem Öffnen des Kollektorkontaktfensters 33 und des Fensters 31 für die intrinsische Basis, wird die Struktur einem Reoxidationsprozeß unterworfen, bei dem sich eine Siliziumdioxidschicht 35 bildet. Da die N-dotierte polykristalline Siliziumschicht etwa 4 mal schneller oxidiert, als das vergleichsweise niedrig dotierte monokristalline Halbleitersubstrat 11, erzeugt die an der Seitenfläche der polykristallinen Siliziumschicht 27 gebildete Oxidschicht 37 eine Barriere für den anschließend zu bildenden Emitter-Basisübergang. Das bedeutet, daß der Emitter-Basisübergang unter thermischem Siliziumdioxid an die Oberfläche des Halbleitersubstrats 11 tritt. Anschließend wird die intrinsische Basiszone 39 durch Ionenimplantation gebildet, wobei als Dotierungsmittel beispielsweise $P^{31}$ oder $As^{75}$ verwendet wird.

Im nächsten Prozeßschritt wird eine zweite polykristalline Siliziumschicht 41 auf die Struktur aufgebracht, wie es in Fig. 7 dargestellt ist. Die zweite polykristalline Siliziumschicht wird mit $B^{11}$ implantiert. Der nachfolgende Verfahrensablauf ist identisch mit dem, anhand der Figuren 1 bis 4 beschriebenen Herstellungsverfahren. Die weiteren im vorliegenden Fall anzuwendenden Prozeßschritte ergeben sich aus den Figuren 7 und 8.

Wichtig im Zusammenhang mit dem erfindungsgemäßen Herstellungsverfahren zur Verwirklichung eines PNP-Transistors sind die Dicke der aufgebrachten polykristallinen Siliziumschicht, die aufgewandte Ionendosis, die Implantationsenergie und die Zeit- und Temperaturbedingungen, denen die Transistorstruktur nach Durchführung des Implantationsprozesses ausgesetzt wird. Bei einer Implantation von Bor oder anderen P-Leitfähigkeit erzeugenden Ionen läßt sich grundsätzlich die Tatsache feststellen, daß die während der Ionenimplantation eingebrachten Schäden nicht ausreichend sind, die monokristalline Struktur aufzubrechen, wenn die Voraussetzung erfüllt ist, daß die Konzentration der Ionen an der Grenzfläche zwischen der polykristallinen Siliziumschicht und dem monokristallinen Halbleitersubstrat geringer ist als die Maximalkonzentration einer kritischen Dotierung. Betrachtet man außerdem die Anforderungen an die notwendige Dosierung, so ist das Eintreiben während eines entsprechenden Erwärmungsprozesses so zu wählen, daß eine sehr flache Emitterzone mit hoher Konzentration und extrem steilem Konzentrationsgradienten erhalten wird, was für einen PNP-Transistor anzustreben ist.

Es ist darauf hinzuweisen, daß die bei der Ionenimplantation angewandte Dosis über der kritischen Dosis liegt, von der man weiß, daß sie irreparable Versetzungsschäden erzeugt. Mit anderen Worten, obwohl die Gesamtdosis über einem bekannten kritischen Wert für das bestimmte Dotierungsmittel liegt, sind die Bedingungen für die Implantation so festgelegt, daß störende Schäden vermieden und ein optimaler Konzentrationsverlauf in einer flachen Emitterzone erhalten wird.

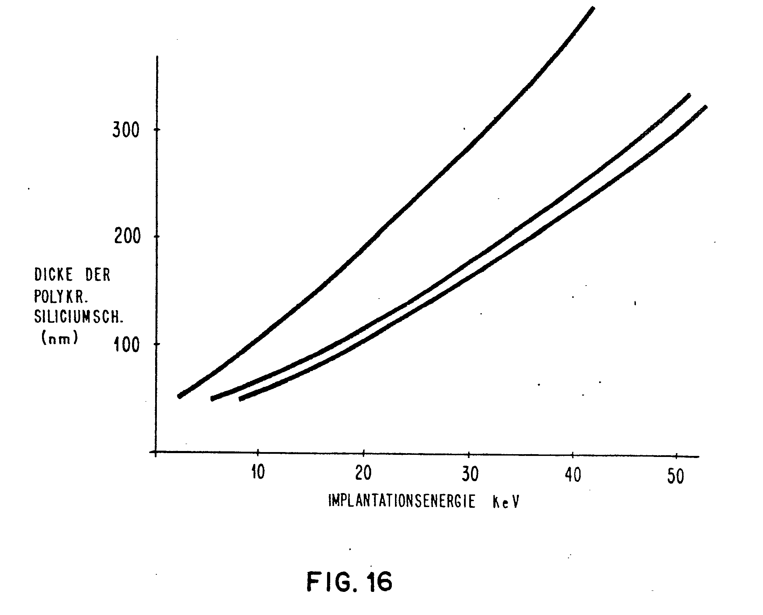

Die kritische Dosis für P-Leitfähigkeit erzeugende Ionen liegt für monokristallines Silizium bei etwa $1 \times 10^{15}$ Ionen/cm$^3$. Die beim erfindungsgemäßen Verfahren zweckmäßige Dosis liegt im Bereich von etwa $1 \times 10^{16}$ bis $1 \times 10^{17}$ Ionen/cm$^2$. Die Implantationsenergie zum Einbringen der Ionen in die polykristalline Siliziumschicht hängt von der Dicke dieser Schicht ab. Der Zusammenhang zwischen Implantationsenergie und Dicke der polykristallinen Siliziumschicht ist der Figur 16 zu entnehmen.

Nach der Implantation der die P-Leitfähigkeit erzeugenden Störstellen in die polykristalline Siliziumschicht werden diese Störstellen in das monokristalline Halbleitersubstrat eingetrieben. Dies geschieht vorzugsweise auf thermischem Wege. Der Erwärmungsprozeß erfolgt mit einer Temperatur von etwa 900 °C bis 1 100 °C, wobei die Dauer des Prozesses bei der niedrigeren Temperatur etwa 90 Minuten und bei der höheren Temperatur etwa 2 Minuten beträgt. Zur leichteren Steuerung des Erwärmungsprozesses wird dieser während einer Dauer von etwa 60 Minuten bei etwa 950 °C und bei einer Dauer von 45 Minuten bei etwa 100 °C durchgeführt. Als bevorzugt geeignet hat sich auch erwiesen, einen Erwärmungsprozeß während einer Dauer von 30 Minuten bei 1 000 °C. Es ist in diesem Zusammenhang darauf hinzuweisen, daß bei der gesamten Wärmebehandlung nach der Implantation äquivalente Bedingungen zu den angegebenen Bedingungen nicht überschritten werden. Sind auch noch für andere implantierte Halbleiterzonen Erwärmungsprozesse zum Zwecke des Eintreibens erforderlich, wie dies beispielsweise für Basiskontaktzonen zutreffen kann, so sollte dieser Erwärmungsprozeß vor oder gleichzeitig mit dem Eintreiben der Emitterzone aus der polykristallinen Siliziumschicht erfolgen.

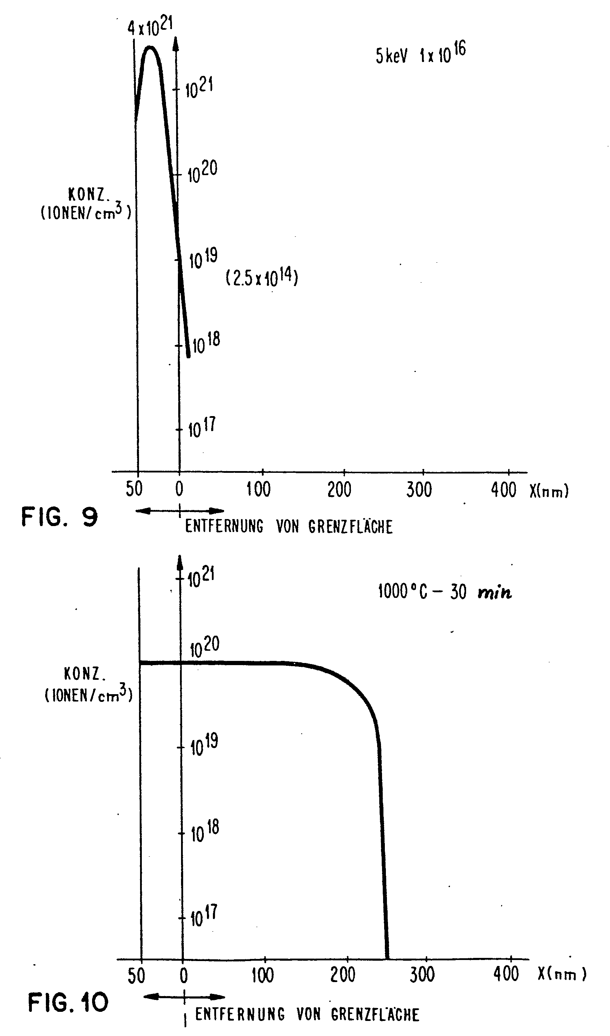

In den Figuren 9 bis 14 werden unterschiedliche Betriebsdaten des erfindungsgemäßen Verfahrens für unterschiedliche Dicken der polykristallinen Siliziumschicht angegeben. So wird im Beispiel der Fig. 9 eine polykristalline Siliziumschicht einer Dicke von 50 nm verwendet. In diese Schicht wird Bor in einer Dosis von $1 \times 10^{16}$ Ionen/cm$^2$ implantiert. Die Implantationsenergie beträgt 5 keV. Unter diesen Bedingungen ergibt sich die, in Fig. 9 angegebene Verteilung der Ionen in der polykristallinen Siliziumschicht. Nach der Implantation wird das Bor in das monokristalline Halbleitersubstrat eingetrieben, um so die Emitterzone des Transistors zu erzeugen. Das Eintreiben erfolgt während einer Dauer von 30 Minuten bei einer Temperatur von 1 000 °C. Das sich für die Emitterzone ergebende Profil ist aus der Fig. 10 zu ersehen. Es ergibt sich eine gleichbleibende Konzentration von $10^{20}$ Ionen/cm$^3$ bis zu einer Tiefe von etwa 200 nm.

Wie der Fig. 9 zu entnehmen ist, beträgt die Konzentration an der Grenzfläche zwischen polykristalliner Siliziumschicht und monokristallinem Halbleitersubstrat etwa $10^{19}$ Ionen/cm$^3$. Die erforderliche Dosis zur Erzielung einer Gauss'schen Verteilung mit einem Maximum bei $10^{19}$ Ionen/cm$^3$ beträgt etwa $2,5 \times 10^{14}$ Ionen/cm$^2$ bei einer Energie von etwa 5 keV. Dieser Wert liegt unterhalb der geforderten kritischen Dosis von $1 \times 10^{15}$ Ionen/cm$^2$. Das heißt also, die Kenngrößen für die Implantation zur Erzeugung der Emitterzone entsprechen den den grundsätzlichen Forderungen, daß nämlich die Konzentration an der Grenzfläche geringer sein soll, als diejenige, die durch eine kritische Dosis erzeugt wird, und deren Verteilungsmaximum in der Grenzfläche liegt.

Die Figuren 11 und 12 zeigen die Verteilung nach der Ionenimplantation und nach Durchführung des Erwärmungsprozesses für eine polykristalline Siliziumschicht mit einer Dicke von 150 nm. Die Implantationsenergie beträgt 25 keV bei einer Dosis von $10^{16}$ Ionen/cm$^2$. Der erforderliche Erwärmungsprozeß wird während einer Dauer von 30 Minuten bei 1 000 °C durchgeführt.

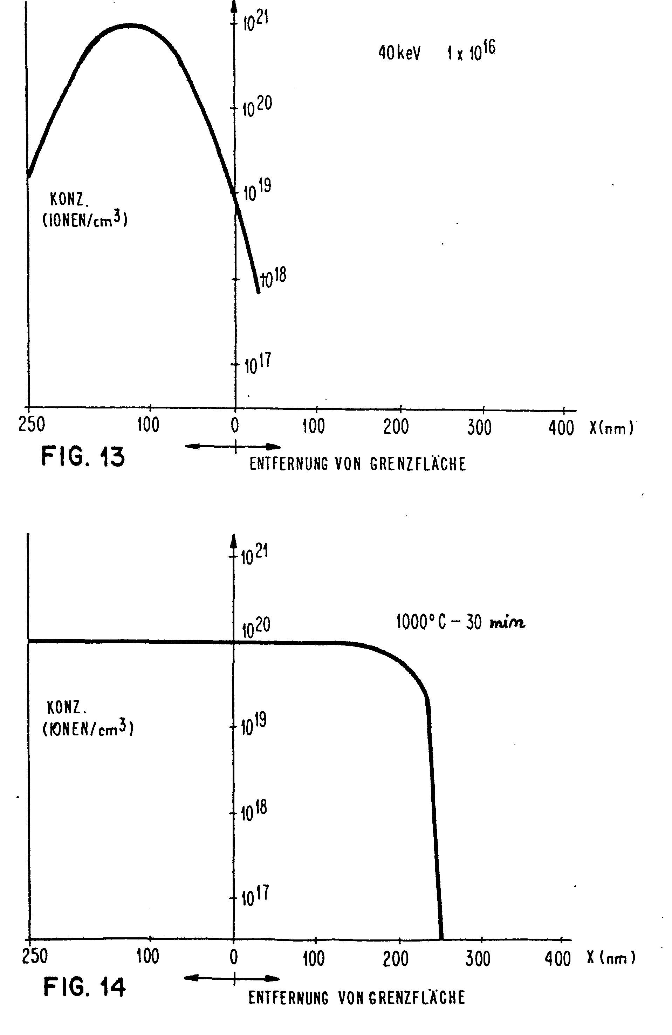

Die Figuren 13 und 14 zeigen das Konzentrationsprofil nach der Ionenimplantation und dem eintreiben für eine polykristalline Siliziumschicht mit einer Dicke von 250 nm. Die Implantationsenergie beträgt 40 keV bei einer Dosis von $10^{16}$ Ionen/cm$^2$. Der Erwärmungsprozeß wird bei einer Dauer von 30 Minuten mit 1 000 °C durchgeführt.

Für sämtliche in den Figuren 9 bis 14 dargestellten Fälle läßt sich feststellen, daß trotz unterschiedlicher Dicke der polykristallinen Siliziumschicht die Emitterzone jeweils das gleiche Konzentrationsmaximum der Ionen bei etwa der gleichen Tiefe aufweist. Das bedeutet, daß die Gesamtionenaufnahme der polykristallinen Siliziumschicht trotz unterschiedlicher Dicke etwa gleich groß ist. Die Gesamtionenaufnahme verdichtet und das Verteilungsmaximum ist höher bei reduzierter Dicke der polykristallinen Siliziumschicht.

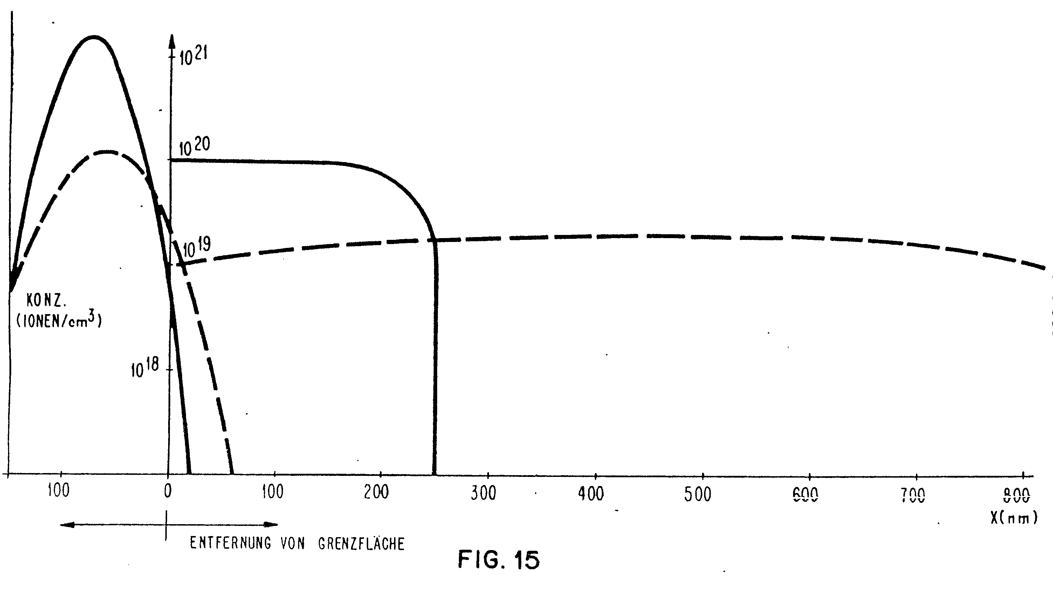

Der Fig. 15 sind die unterschiedlichen Daten des erfindungsgemäßen Verfahrens verglichen mit einem zum Stande der Technik gehörenden Verfahren zu entnehmen. Dem Verfahren aus dem eingangs zitierten Artikel in « Japanese Journal of Applied Physics » entspricht eine Ionenimplantation von Bor in eine polykristalline Siliziumschicht, wie sie durch die gestrichelte Linie in Fig. 15 angegeben ist. Die Implantation von Bor erfolgt dabei mit einer Dosis, die etwa der kritischen Dosis entspricht, d. h., einer Dosis von $1 \times 10^{15}$ Ionen/cm$^2$ bei einer Dicke der polykristallinen Siliziumschicht von 150 nm. Die Störstellenverteilung in der polykristallinen Siliziumschicht ergibt sich aus der gestrichelten Kurve links von der die Grenzfläche kennzeichnenden vertikalen Linie. Nach dem Eintreiben ergibt sich eine Basiszone, deren Verteilung im monokristallinen Halbleitersubstrat sich aus der gestrichelten Linie rechts von der Grenzfläche ergibt.

Beim erfindungsgemäßen Verfahren, bei dem eine Dosis über der kritischen Dosis von $1 \times 10^{16}$ Ionen/cm² bei einer Energie von 25 keV angewandt wird, ergibt sich die aus der durchgezogenen Linie erkennbare Störstellenverteilung links von der Grenzfläche, also in der polykristallinen Siliziumschicht. Nach Durchführung des Erwärmungsprozesses weist die im Halbleitersubstrat gebildete Emitterzone eine Störstellenverteilung, wie sie durch die ausgezogene Linie rechts von der Grenzfläche angegeben ist.

Beim erfindungsgemäßen Verfahren wird eine Dosis von etwa $1 \times 10^{16}$ bis $1 \times 10^{17}$ Ionen/cm² angewandt, um die angestrebte Gesamtionenaufnahme in der polykristallinen Halbleiterschicht zu erzielen. Die erforderliche Implantationsenergie um diese Dosis zu implantieren und die gewünschte Störstellenverteilung zu erzielen, hängt von der Dicke der polykristallinen Siliziumschicht ab. Allgemein ergibt sich die optimale Energie aus der mittleren Kurve in Fig. 16. Andere Energien können angewandt werden, wobei sich die Maximal- und Minimalwerte aus der oberen und der unteren Kurve in Fig. 16 ergeben. Für eine polykristalline Siliziumschicht mit einer Dicke von 50 nm kann eine Implantationsenergie im Bereich von 2 bis 8 keV aufgewandt werden. Bei einer Dicke der polykristallinen Siliziumschicht von 150 nm ist eine Implantationsenergie im Bereich von 15 bis 27 keV ein brauchbarer Wert. Ein Wert für eine polykristalline Siliziumschicht mit einer Dicke von 250 nm liegt im Bereich von 25 bis 43 keV.

**Ansprüche**

1. Verfahren zum Herstellen eines vertikalen PNP-Transistors mit flacher, einen steilen Störstellengradienten bei hoher Störstellenkonzentration aufweisender und fehlstellenfreier P-dotierter Emitterzone (23) in einer in ein P-dotiertes Halbleitersubstrat (11) eingebrachten N-dotierten Basiszone (10), wobei im Bereich der Basiszone (10) ein die Emitterzone (23) definierendes Maskenfenster (19) erzeugt wird, eine polykristalline Siliziumschicht (21) im Bereich des Maskenfensters (19) aufgebracht wird, die polykristalline Siliziumschicht (21) durch Implantation von eine P-Leitfähigkeit erzeugenden Störstellen dotiert wird und in einem anschließenden Eintreibprozeß Störstellen aus der polykristallinen Siliziumschicht (21) in die Basiszone (10) eindiffundiert werden und dort die Emitterzone (23) bilden, dadurch gekennzeichnet, daß die Implantation mit einer oberhalb des kritischen, irreparable Versetzungsschäden erzeugenden Wertes liegenden Dosis erfolgt und daß die Implantationsparameter so gewählt werden, daß die Konzentration der Störstellen im Bereich der Grenzfläche zwischen der polykristallinen Siliziumschicht (21) und dem monokristallinen Halbleitersubstrat (11) kleiner ist als die Konzentration, die sich bei einer kritischen Dosis mit dem Konzentrationsmaximum in dieser Grenzfläche ergäbe.

2. Verfahren nach Anspruch 1, dadurch gekennzeichnet, daß als Störstellen Borionen dienen.

3. Verfahren nach Anspruch 1 oder 2, dadurch gekennzeichnet, daß bei der Implantation eine Dosis von mindestens etwa $1 \times 10^{16}$ Ionen/cm² gewählt wird.

4. Verfahren nach einem der Ansprüche 1 bis 3, dadurch gekennzeichnet, daß für die polykristalline Siliziumschicht eine Dicke von etwa 50 bis 300 nm gewählt wird.

5. Verfahren nach Anspruch 4, dadurch gekennzeichnet, daß bei der Implantation von Borionen eine Dosis von etwa $1 \times 10^{16}$ bis etwa $1 \times 10^{17}$ Ionen/cm² und eine Implantationsenergie von etwa 2 bis 50 keV gewählt wird.

6. Verfahren nach den Ansprüchen 1 bis 5, dadurch gekennzeichnet, daß das Eintreiben durch eine Wärmebehandlung bei einer Temperatur von etwa 900 bis etwa 1 100 °C und einer Dauer von etwa 90 Minuten bei der niedrigeren und einer Dauer von etwa 2 Minuten bei der höheren Temperatur erfolgt.

7. Verfahren nach den Ansprüchen 1 bis 5, dadurch gekennzeichnet, daß das Eintreiben durch eine Wärmebehandlung bei einer Temperatur von etwa 950 °C in etwa 1 000 °C und einer Dauer von etwa 60 Minuten bei der niedrigeren und einer Dauer von etwa 45 Minuten bei der höheren Temperatur erfolgt.

8. Verfahren nach den Ansprüchen 1 bis 5, dadurch gekennzeichnet, daß das Eintreiben durch eine Wärmebehandlung erfolgt, die einer Temperatur von etwa 1 000 °C und einer Dauer von etwa 30 Minuten entspricht.

9. Verfahren nach den Ansprüchen 1 bis 5, dadurch gekennzeichnet, daß das Eintreiben durch eine Wärmebehandlung erfolgt, bei der die Ionen weniger als etwa 250 nm in das Halbleitersubstrat eindiffundiert werden.

10. Vertikaler PNP-Transistor, insbesondere hergestellt nach dem Verfahren gemäß der Ansprüche 1 bis 9, gekennzeichnet durch eine Emitterzone mit einer Konzentration von mindestens etwa $1 \times 10^{19}$ Ionen/cm³ bis zu einer Entfernung von mindestens etwa 200 nm von der Oberfläche und einer Konzentration von weniger als etwa $1 \times 10^{16}$ Ionen/cm³ in einer Entfernung von 350 nm.

11. Vertikaler PNP-Transistor, insbesondere hergestellt nach dem Verfahren gemäß den Ansprüchen 1 bis 9, gekennzeichnet durch eine Emitterzone mit einer Konzentration von mindestens etwa $5 \times 10^{19}$ Ionen/cm³ bis zu einer Entfernung von mindestens etwa 150 nm von der Oberfläche und einer Konzentration von weniger als etwa $1 \times 10^{17}$ Ionen/cm³ in einer Entfernung von 300 nm.

## Claims

1. Method of making a vertical PNP-transistor with shallow defect-free, P-doped emitter region (23) having a high impurity gradient with high impurity concentration in an N-doped base region (10) provided in a P-doped semiconductor substrate (11), a mask window (19) being produced in the zone of the base region (10) and defining the emitter region (23), a polycrystalline silicon layer (21) being applied in the zone of the mask window (19), the polycrystalline silicon layer (21) being doped through the implantation of P-conductivity-producing impurities, and in a subsequent drive-in process impurities being diffused from the polycrystalline silicon layer (21) into the base region (10), forming the emitter region (23) there, characterized in that the implantation is effected with a dose above the value generating critical and irreparable dislocations, and that the implantation parameters are selected to such an effect that the concentration of the impurities in the zone of the interface between the polycrystalline silicon layer (21) and the monocrystalline semiconductor substrate (11) is smaller than the concentration which would be obtained with a critical dose with the concentration maximum in this interface.

2. Method as claimed in claim 1, characterized in that boron ions are used as impurities.

3. Method as claimed in claim 1 or 2, characterized in that for the implantation a dose of at least $1 \times 10^{16}$ ions/cm$^2$ is selected.

4. Method as claimed in any one of claims 1 to 3, characterized in that for the polycrystalline silicon layer a thickness of approximately 50 to 300 nm is selected.

5. Method as claimed in claim 4, characterized in that for the implantation of boron ions a dose of approximately $1 \times 10^{16}$ to approximately $1 \times 10^{17}$ ions/cm$^2$, and an implantation energy of approximately 2 to 50 keV is selected.

6. Method as claimed in any one of claims 1 to 5, characterized in that the drive-in process is effected through a heat treatment at a temperature of approximately 900 °C to approximately 1 100 °C, and a duration of approximately 90 minutes at the lower, and a duration of approximately 2 minutes at the higher temperature.

7. Method as claimed in any one of claims 1 to 5, characterized in that the drive-in process is effected by a heat treatment at a temperature of approximately 950 °C to approximately 1 000 °C and a duration of approximately 60 minutes for the lower, and a duration of approximately 45 minutes at the higher temperature.

8. Method as claimed in any one of claims 1 to 5, characterized in that the drive-in process is effected by a heat treatment which corresponds to a temperature of approximately 1 000 °C and a duration of approximately 30 minutes.

9. Method as claimed in any one of claims 1 to 5, characterized in that the drive-in process is effected by a heat treatment in which the ions are diffused into the semiconductor substrate for less than approximately 250 nm.

10. Vertical PNP-transistor, made in particular according to the method as claimed in any one of claims 1 to 9, characterized by an emitter region with a concentration of at least approximately $1 \times 10^{19}$ ions/cm$^3$ to a distance of at least approximately 200 nm from the surface, and a concentration of less than approximately $1 \times 10^{16}$ ions/cm$^3$ at a distance of 350 nm.

11. Vertical PNP-transistor, made in particular in accordance with the method as claimed in any one of claims 1 to 9, characterized by an emitter region with a concentration of at least approximately $5 \times 10^{19}$ ions/cm$^3$ to a distance of at least approximately 150 nm from the surface, and a concentration of less than approximately $1 \times 10^{17}$ ions/cm$^3$ at a distance of 300 nm.

## Revendications

1. Procédé de fabrication d'un transistor PNP vertical possédant une région d'émetteur (23) peu profonde à dopage P sans défauts et présentant un gradient de concentration élevé, dans une région de base (10) à dopage N placée dans un substrat semi-conducteur (11) à dopage P, une fenêtre de masquage (19) définissant la région d'émetteur (23) ayant été créée à proximité de la région de base (10), une couche polycristalline de silicium (21) étant déposée à proximité de la fenêtre de masquage (19), la couche polycristalline de silicium (21) étant dopée par implantation de dopants générant une conductibilité P, les dopants étant diffusés dans la région de base (10) à partir de la couche polycristalline de silicium (21) au cours d'un processus final d'étalement pour y constituer la région d'émetteur (23), procédé de fabrication caractérisé par le fait que l'implantation s'effectue avec une dose supérieure à la valeur critique causant des dislocations irréparables, et par le fait que les paramètres d'implantation ont été choisis de manière à ce que la concentration des dopants à proximité des interfaces entre la couche polycristalline de silicium (21) et le substrat monocristallin semi-conducteur (11) soit inférieure à la concentration que l'on obtiendrait pour une dose critique avec la concentration maximale dans cette interface.

2. Procédé selon la revendication 1 caractérisé par l'utilisation d'ions de bore comme dopant.

3. Procédé selon la revendication 1 ou 2, caractérisé par le choix, lors de l'implantation, d'une dose minimale d'environ $1 \times 10^{16}$ ions/cm$^2$.

4. Procédé selon l'une des revendications 1 à 3, caractérisé par le choix d'une épaisseur de la couche polycristalline de silicium d'environ 50 à 300 nm.

5. Procédé selon la revendication 4, caractérisé par le choix d'une dose d'environ $1 \times 10^{16}$ à environ $1 \times 10^{17}$ ions/cm$^2$ et d'une énergie d'implantation d'environ 2 à 50 keV lors de l'implantation d'ions de bore.

6. Procédé selon une des revendications 1 à 5, caractérisé par le fait que l'étalement s'effectue par un traitement thermique à une température approximative comprise entre 900 et 1 100 °C, avec une durée d'environ 90 minutes à la température inférieure et une durée d'environ 2 minutes à la température la plus élevée.

7. Procédé selon l'une des revendications 1 à 5, caractérisé par le fait que l'étalement s'effectue par un traitement thermique à une température approximative comprise entre 950 et 1 000 °C, avec une durée d'environ 60 minutes à la température inférieure et une durée d'environ 45 minutes à la température la plus élevée.

8. Procédé selon l'une des revendications 1 à 5, caractérisé par le fait que l'étalement s'effectue par un traitement thermique correspondant à une température d'environ 1 000 °C et à une durée d'environ 30 minutes.

9. Procédé selon l'une des revendications 1 à 5, caractérisé par le fait que l'étalement s'effectue par un traitement thermique au cours duquel les ions sont diffusés à une profondeur inférieure à 250 nm environ dans le substrat semi-conducteur.

10. Transistor PNP vertical fabriqué en particulier selon le procédé d'une des revendications 1 à 9, caractérisé par une région d'émetteur de concentration minimale d'environ $1 \times 10^{19}$ ions/cm$^3$ jusqu'à une distance minimale d'environ 200 nm de la surface, et de concentration inférieure à environ $1 \times 10^{16}$ ions/cm$^3$ à une distance de 350 nm.

11. Transistor PNP vertical fabriqué en particulier selon le procédé d'une des revendications 1 à 9, caractérisé par une région d'émetteur de concentration minimale d'environ $5 \times 10^{19}$ ions/cm$^3$ jusqu'à une distance minimale d'environ 150 nm de la surface, et de concentration inférieure à environ $1 \times 10^{17}$ ions/cm$^3$ à une distance de 300 nm.

FIG. 1

FIG. 2

FIG. 3

FIG. 4

1

FIG. 5

FIG. 6

FIG. 7

FIG. 8

5keV 1x10^{16}

KONZ.
(IONEN/cm^3)

(2.5 x 10^{14})

FIG. 9

ENTFERNUNG VON GRENZFLÄCHE

1000°C — 30 *min*

KONZ.
(IONEN/cm^3)

FIG. 10

ENTFERNUNG VON GRENZFLÄCHE

3

~ 25 keV    $1 \times 10^{16}$

KONZ.
(IONEN/cm$^3$)

$10^{21}$
$10^{20}$
$10^{19}$
$10^{18}$
$10^{17}$

150    0    100    200    300    400    X(nm)

**FIG. 11**    ENTFERNUNG VON GRENZFLÄCHE

$10^{21}$
$10^{20}$

1000°C − 30 min

KONZ.
(IONEN/cm$^3$)

$10^{19}$
$10^{18}$
$10^{17}$

150    0    100    200    300    400    X(nm)

**FIG. 12**    ENTFERNUNG VON GRENZFLÄCHE

40 keV    $1 \times 10^{16}$

KONZ.
(IONEN/$cm^3$)

$10^{21}$

$10^{20}$

$10^{19}$

$10^{18}$

$10^{17}$

250    100    0    100    200    300    400    X(nm)

FIG. 13

ENTFERNUNG VON GRENZFLÄCHE

$1000°C - 30$ *min*

KONZ.
(IONEN/$cm^3$)

$10^{21}$

$10^{20}$

$10^{19}$

$10^{18}$

$10^{17}$

250    100    0    100    200    300    400    X (nm)

FIG. 14

ENTFERNUNG VON GRENZFLÄCHE

KONZ.
(IONEN/cm³)

$10^{21}$

$10^{20}$

$10^{19}$

$10^{18}$

100    0    100    200    300    400    500    600    700    800

X(nm)

ENTFERNUNG VON GRENZFLÄCHE

FIG. 15

0 029 887

FIG. 16